# EUROPEAN PATENT APPLICATION

(11) **EP 4 597 131 A1**
(43) Date of publication of application: **06.08.2025**
(21) Application number: 25150665.5
(22) Date of filing: 08.01.2025
(51) Int. Cl.: G01R 31/34, G01R 31/42, H02P 29/024

(54) **FAULT DETECTION IN AN ELECTRICAL POWER SYSTEM**

(30) Priority: 25.01.2024 GB 202400988
(71) Applicant: Rolls-Royce plc, London N1 9FX (GB)
(72) Inventor: Sathyanarayan, Rajaram, Derby, DE24 8BJ (GB); Nadarajan, Sivakumar, Derby, DE24 8BJ (GB); Vaiyapuri, Viswanathan, Derby, DE24 8BJ (GB); Narasimalu, Srikanth, Derby, DE24 8BJ (GB); Gupta, Amit, Derby, DE24 8BJ (GB)
(74) Representative: Rolls-Royce plc

(57) **Abstract**

The disclosure relates to a fault detection method for an electrical power system (100) comprising a power electronics converter (102) connected to an electrical machine (101), the method comprising: i) measuring an electric current (la, lb) through a winding of the electrical machine over a measurement time period to acquire a first set of time domain current data; ii) transforming the first set of time domain current data to the frequency domain to provide a set of frequency domain current data; iii) dividing the set of frequency domain current data into a plurality of frequency bands, each frequency band containing a harmonic frequency of operation of the electrical machine; iv) transforming each of the plurality of frequency bands into the time domain to provide a second set of time domain current data for each frequency band; v) calculating a plurality of statistical measures of each second set of time domain current data; vi) applying principal components analysis to the plurality of statistical measures for each second set of time domain current data; vii) calculating a Mahalanobis distance for each second set of time domain data; and viii) determining a fault if any of the calculated Mahalanobis distances is anomalous compared to a baseline measure.

## Description

### TECHNICAL FIELD

The disclosure relates to detection of incipient faults in components of electrical power systems.

### BACKGROUND

It is important to ensure reliability and availability of electrical assets used in power and propulsion systems, in particular for safety and mission critical applications such as aerospace. In general, electrical assets are subject to various failure modes that may involve power converter faults, electrical machine faults and mechanical faults. Power converter faults may for example involve failure of DC link capacitors or semiconductor switching components. Electrical machine faults may for example involve turn-to-turn or inter-turn short circuits. Mechanical faults may for example include bearing faults. Electrical assets in aerospace applications are also designed to operate in harsh environments and may be exposed to high electrical, thermal and mechanical stresses. Detection of incipient faults in such electrical assets can therefore be useful to assist in improving their reliability and availability.

### SUMMARY

According to a first aspect there is provided a fault detection method for an electrical power system comprising a power electronics converter connected to an electrical machine, the method comprising:
i) measuring an electric current through a winding of the electrical machine over a measurement time period to acquire a first set of time domain current data;
ii) transforming the first set of time domain current data to the frequency domain to provide a set of frequency domain current data;
iii) dividing the set of frequency domain current data into a plurality of frequency bands, each frequency band containing a harmonic frequency of operation of the electrical machine;
iv) transforming each of the plurality of frequency bands into the time domain to provide a second set of time domain current data for each frequency band;
v) calculating a plurality of statistical measures of each second set of time domain current data;
vi) applying principal components analysis to the plurality of statistical measures for each second set of time domain current data;
vii) calculating a Mahalanobis distance for each second set of time domain data; and
viii) determining a fault if any of the calculated Mahalanobis distances is anomalous compared to a baseline measure.

The method may be carried out over a plurality of measurement time periods to acquire a plurality of first sets of time domain current data.

Step viii) may comprise determining a maximum difference between the calculated Mahalanobis distances and the baseline measure over the plurality of measurement time periods.

Step ii) may comprise defining each frequency band by a central frequency, an upper bound frequency and a lower bound frequency, each central frequency corresponding to a fundamental frequency or harmonic frequency of operation of the electrical machine.

For each frequency band the upper bound frequency may be 50% above the central frequency and the lower bound frequency 50% below the central frequency.

Step i) may comprise acquiring the first set of time domain current data by sampling the current data at a sampling frequency over a predetermined number of samples.

The plurality of frequency bands may comprise a fundamental frequency band and first, second, third and fourth harmonic frequency bands.

The plurality of statistical measures may include kurtosis, RMS, skewness and variance.

The fault may be in the electrical machine, or in a bearing or a gearbox coupled to the electrical machine.

According to a second aspect there is provided an electrical power system comprising:
a DC power source;
an electrical machine;
a power electronics converter connected to convert a DC supply from the DC power source to an AC supply for driving the electrical machine;
a mechanical load connected to the electrical machine; and
a condition monitoring unit configured to:
   i) measure an electric current through a winding of the electrical machine over a measurement time period to acquire a first set of time domain current data;
   ii) transform the first set of time domain current data to the frequency domain to provide a set of frequency domain current data;
   iii) divide the set of frequency domain current data into a plurality of frequency bands, each frequency band containing a harmonic frequency of operation of the electrical machine;
   iv) transform each of the plurality of frequency bands into the time domain to provide a second set of time domain current data for each frequency band;
   v) calculate a plurality of statistical measures of each second set of time domain current data;
   vi) apply principal components analysis to the plurality of statistical measures for each second set of time domain current data;
   vii) calculate a Mahalanobis distance for each second set of time domain data; and
   viii) determine a fault if any of the calculated Mahalanobis distances is anomalous compared to a baseline measure.

The condition monitoring unit may be configured to measure the electric current over a plurality of measurement time periods to acquire a plurality of first sets of time domain current data.

In step viii) the condition monitoring unit may be is configured to determine a fault based on a maximum difference between the calculated Mahalanobis distances and the baseline measure over the plurality of measurement time periods.

Each frequency band may be defined by a central frequency, an upper bound frequency and a lower bound frequency, each central frequency corresponding to a fundamental frequency or harmonic frequency of operation of the electrical machine.

For each frequency band the upper bound frequency may be 50% above the central frequency and the lower bound frequency 50% below the central frequency.

The condition monitoring unit may be configured to acquire the first set of time domain current data by sampling the current data at a sampling frequency over a predetermined number of samples.

The plurality of frequency bands may comprise a fundamental frequency band and first, second, third and fourth harmonic frequency bands.

The plurality of statistical measures may include kurtosis, RMS, skewness and variance.

The fault may be in the electrical machine or in a bearing or gearbox coupled to the electrical machine.

According to a third aspect there may be provided a computer program comprising instructions to cause a computer to perform the method according to the first aspect. The computer program may be provided on a non-volatile computer-readable medium.

The skilled person will appreciate that except where mutually exclusive, a feature described in relation to any one of the above aspects may be applied mutatis mutandis to any other aspect. Furthermore except where mutually exclusive any feature described herein may be applied to any aspect and/or combined with any other feature described herein.

### BRIEF DESCRIPTION OF THE DRAWINGS

Embodiments will now be described by way of example only with reference to the accompanying drawings, which are purely schematic and not to scale, and in which:
**Figure 1** is a schematic diagram of an example electrical power system;
**Figure 2** is a flow diagram of an example fault detection method for the electrical power system of Figure 1;
**Figure 3a** is an example plot of T² measures over different frequency bands for an electrical power system with and without a fault;
**Figure 3b** is a plot of band 2 of the T² measures from Figure 3a;
**Figure 4a** is another example plot of T² measures over different frequency bands for an electrical power system with and without a fault;
**Figure 4b** is a plot of band 2 of the T² measures from Figure 4a;
**Figure 4c** is a plot of band 4 of the T² measures from Figure 4a;
**Figure 5a** is another example plot of T² measures over different frequency bands for an electrical power system with and without a fault; and **Figure 5b** is a plot of band 5 of the T² measures from Figure 5a.

### DETAILED DESCRIPTION

Aerospace applications have strict space and weight constraints, hence addition of sensors for Equipment Health Monitoring (EHM) would require careful investigation and often it is not acceptable to install additional sensors for EHM. Hence, a novel approach is required to detect faults in electrical assets without additional sensor i.e. leverage existing sensor data.

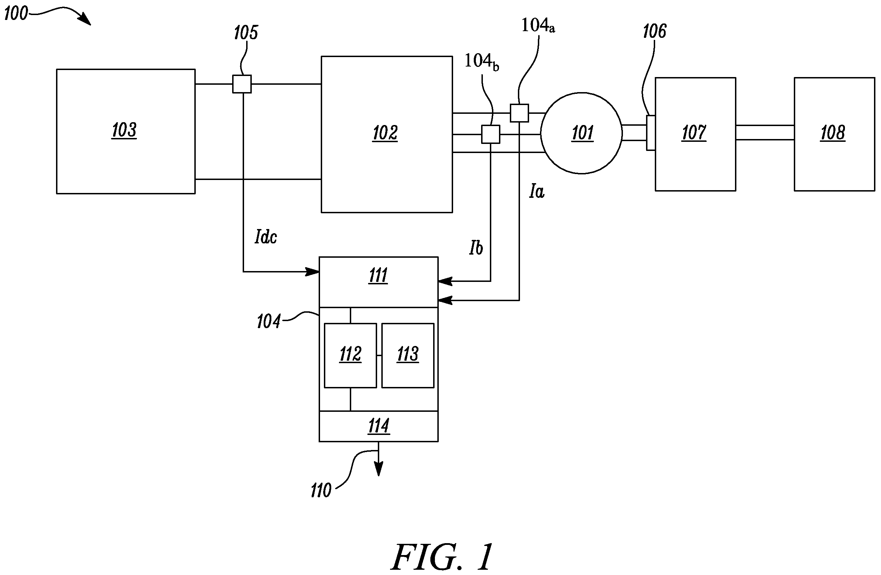

Figure 1 illustrates an example electrical power system 100 arranged to monitor and detecting a fault. The electrical power system 100 comprises a DC power supply 103, which provides DC power to a power electronics converter, or inverter 102. The inverter 102 provides AC power to an electrical machine 101. The electrical machine 101 comprises a plurality of phases, in this example three phases. When operating as a motor, each of the three phase windings in the electrical machine 101 is driven by the inverter 102. The inverter 102 may also operate in reverse, i.e. transforming AC power from the electrical machine 101 operating as a generator to DC power for storage in the DC supply 103. The electrical machine 101 may operate as a motor or as a generator. The electrical machine 101 is connected to a load 108 via a gearbox 107. A driving shaft 109 between the electrical machine 101 and the gearbox 107 is mounted to a bearing 106. The various features in Figure 1 are provided as an example illustration. Alternative arrangements may also be possible, for example an arrangement where the electrical machine 101 is connected to the load 108 without an intervening gearbox 107. Typical implementations will comprise a plurality of bearings and may include more than one gearbox.

A health or condition monitoring unit 104 receives AC stator current measurements signals Ia1, Ib1 from stator current sensors 104ₐ, 104_{b} connected to sense current flowing through the windings of the electrical machine 101 and may also receive a DC link current measurement signal Idc from DC link current sensor 105 connected to sense current flowing from the DC power supply 103. The condition monitoring unit 104 may also receive other signals from the system 100 such as DC and AC voltage measurements and other measurements such as rotational speed and torque on the electrical machine 101.

Currents through each of the stator phases may be measured, although may need to be measured in only some of the phases. In a three-phase electrical machine, the current in only two of the phases needs to be measured, since the current in the third phase can be deduced from the other two currents. For the three currents Ia, Ib, Ic flowing through the windings of the electrical machine 101, the current through phase c can be extracted using the relationship Ia+Ib+Ic=0, i.e. Ic=-la-lb.

Based on these measurements of current supplied to the inverter 102 and through each of the stator phases in the electrical machine 101, the condition monitoring unit 104 performs calculations and provides an output indicating whether a fault may be present in the electrical power system 100, for example a fault in the electrical machine 101, in the inverter 102 or in the mechanical components connected to the electrical machine 101 such as a bearing 106 or gearbox 107.

The condition monitoring unit 104 may be a separate component to the inverter 102 or, in some arrangements, may be provided as part of the inverter 102. The condition monitoring unit 104 may be implemented using general purpose computer hardware, i.e. with an input interface 111 for receiving current measurements from current sensors 104ₐ, 104_{b}, an output interface 114 for providing an output 110 indicating the condition of the system 100, a processing module 112 for carrying out calculations and a memory module 113 for storing data and instructions for the processing module 112. The method of fault detection described herein may therefore be defined as a computer-implemented method and may be embodied by instructions for causing a computer to perform the method.

Current methods of fault detection for the inverter 102 may involve monitoring the stator currents and voltages and estimating the on-state resistance of the inverter 102 to determine a power converter fault. For detecting bearing 106 and gearbox 107 faults connected to the electrical machine 101, characteristic fault frequencies may be monitored. To overcome the difficulty of using different approaches for the detection of different faults in the electrical power system 100, a unified approach based on PCA (principal component analysis) is proposed herein, in which a single framework can be used detect both converter and machine faults.

In an example of the proposed method of fault detection, a time domain current signal is extracted and discretised into multiple sets. In a specific example, each set may consist of 51201 points, corresponding to a sampling frequency of data acquisition. Multiple harmonic bands in each set are selected based on fundamental and harmonic frequencies, each within a bandwidth defined by a lower bound frequency and an upper bound frequency. Significant features in each band such as RMS value, skewness, kurtosis and variance are computed for each individual band. These features are analysed using PCA and a T² algorithm. A T² statistic is calculated for each set and for each band within each set. The T² statistic can then be used as an indicator to detect various electromechanical faults based on the T² statistic defining a distance of each observation from the PCA centre in PCA space. The further the T² statistic is away from the PCA centre, the more this indicates a fault in the system 100.

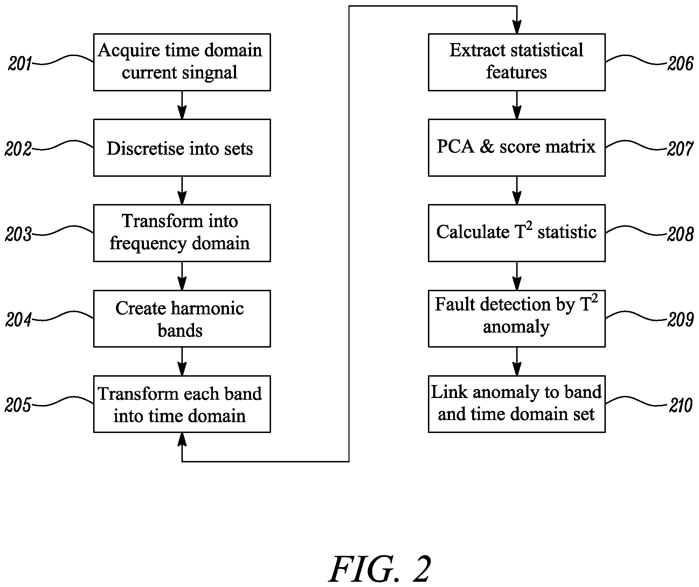

Figure 2 is an example flow diagram illustrating a sequence of steps for condition monitoring of an electrical power system.

In a first step 201, the time domain current signals are acquired for the electrical system 100. The current signals are sampled at a sampling frequency and a series of data points of current amplitude as a function of time acquired.

In step 202, each time domain signal is discretised into multiple sets. In a particular example, one set of a time domain signal may consist of 51,201 data points, corresponding to a sampling frequency of 51.2 kHz, resulting in each set sampling a signal over a 1 second time period. Ten such consecutive sets spanning the data set space will consist of 512,010 data points.

In step 203, each of the time domain signal sets is transformed into the frequency domain so that frequency analysis can be performed on each set.

In step 204, each set is divided into harmonic bands. These harmonic bands are created by representing the harmonic frequencies as central frequencies, F_{c}. The harmonic frequencies are selected for analysis because fault information will tend to lie around these frequencies. By selecting each band with defined upper and lower bound frequencies, any fault frequencies are potentially covered.

A lower bound frequency Fₗ and an upper bound frequency Fᵤ are calculated to define the band. The lower bound frequency may be calculated as F_{c}-50%F_{c} and the upper bound frequency may be calculated as F_{c}+50%F_{c}. The central frequencies F_{c1-n} define the 1st to nth harmonic frequencies, with each harmonic band defined by the lower bound frequency Fₗ₁₋ₙ and an upper bound frequency Fᵤ₁₋ₙ.

In a particular example, the fundamental frequency for a three-phase electrical machine operating at 1500 rpm is 75Hz, so F_{c}=75Hz, Fₗ=75-0.5*75=37.5Hz and Fᵤ=75+0.5*75=112.5Hz. The fundamental frequency may be determined by detecting a peak in the frequency domain current data. Each of the harmonic frequencies are then derived from multiples of the fundamental frequency.

In step 205, each harmonic band is transformed back into the time domain.

In step 206, statistical features such as Kurtosis, RMS value, Skewness and Variance are extracted for each time domain band separately.

In step 207, PCA is performed on the set of statistical features of each time domain band and a score matrix obtained as an output of the PCA calculations. A constraint of 95% variance may be applied to retain the features and principal components of each set. Data outside of the 95% variance constraint may be discarded.

In step 208, a T² statistic, that is the Mahalanobis distance in the PCA space, is calculated for each set. An example process for calculating a T² statistic for each set may comprise:
i) Scaling the data set baseline to have zero mean and unity variance;
ii) Calculating the covariance matrix of the set;
iii) Calculating the eigenvalues and eigenvector of the matrix;
iv) Determining a number of principal components to be retained;
v) Calculating the T² control limit, defining upper and lower limits for the T² values;
vi) Scaling the new data set, i.e. normalising the data set to a common range, for example between 0 and 1;
vii) Projecting the new data set onto the retained principal components; and
viii) Calculating a T² measure for each sample set, the T² measure being the Mahalanobis distance of each observation from the PCA center in the principal component space. The Mahalanobis distance indicates whether each point is an outlier compared to a baseline.

In step 209, the T² measures are used to determine the presence of a fault by determining if any of the T² measures exceed the control limit. In step 210, any anomaly in the T² measures may then be linked to a band and time domain set.

In an example implementation, a permanent magnet electrical motor is driven by a power electronics converter, the electrical motor being connected to a gearbox, a schematic representation of which is shown in Figure 1. The above described method was used to determine the presence of a fault in the gearbox or in a bearing connected to the electrical motor. The current provided to the electrical motor was sampled at 51.2 kHz, with 10 sets of data sampled, each set covering 51,200 points, resulting in a data set space comprising 512,000 data points measured over a 10 second period. In each of the examples described below, the motor was operated at 1500 rpm and at a 20% rated load. The frequency bands were determined to be: band 1 around the fundamental frequency at 75 Hz, ranging from a lower bound at 37.5 Hz to an upper bound at 112.5 Hz; band 2 around 150 Hz, ranging from 112.5 Hz to 187.5 Hz; and bands 3, 4 and 5 around 225 Hz, 300 Hz and 375 Hz respectively. The data sampling, processing and extraction of statistical features were performed using functions available in Matlab.

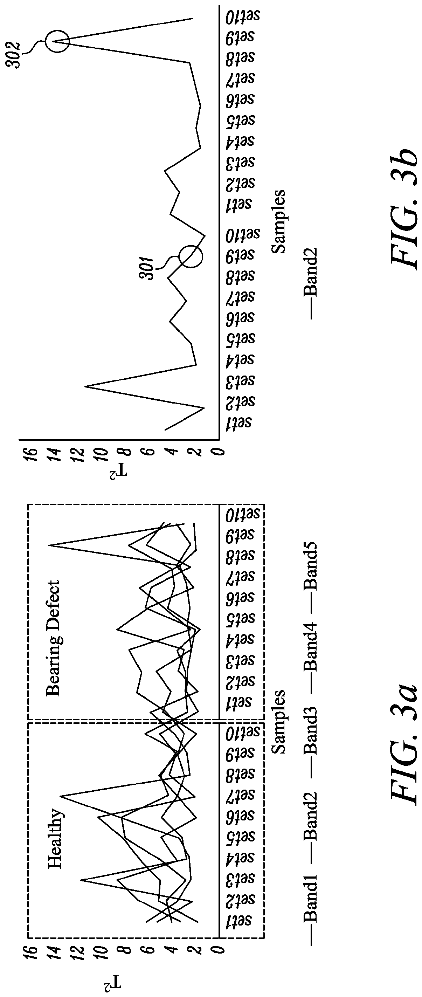

Figure 3a illustrates the T² measures for 10 sets of time domain data covering five bands for a system with no faults (left hand side) and for another 10 sets of time domain data with a known bearing fault (right hand side), in this example in which an outer race of a bearing has a defect. Based on these results, the T² measure can be determined for the faulty system with respect to the healthy system. It can be observed that the T² measure increases significantly for band 2, which in this example is the frequency band between 112.5 Hz and 187.5 Hz, i.e. covering the first harmonic frequency. The results for band 2 are illustrated separately in Figure 3b. Set 9 of band 2 (in this example covering data points 409608 to 460809) demonstrates a maximum difference between the sets of data, indicating a significant variation between the T² measure in the healthy system 301 and the faulty system 302, as indicated in Figure 3b.

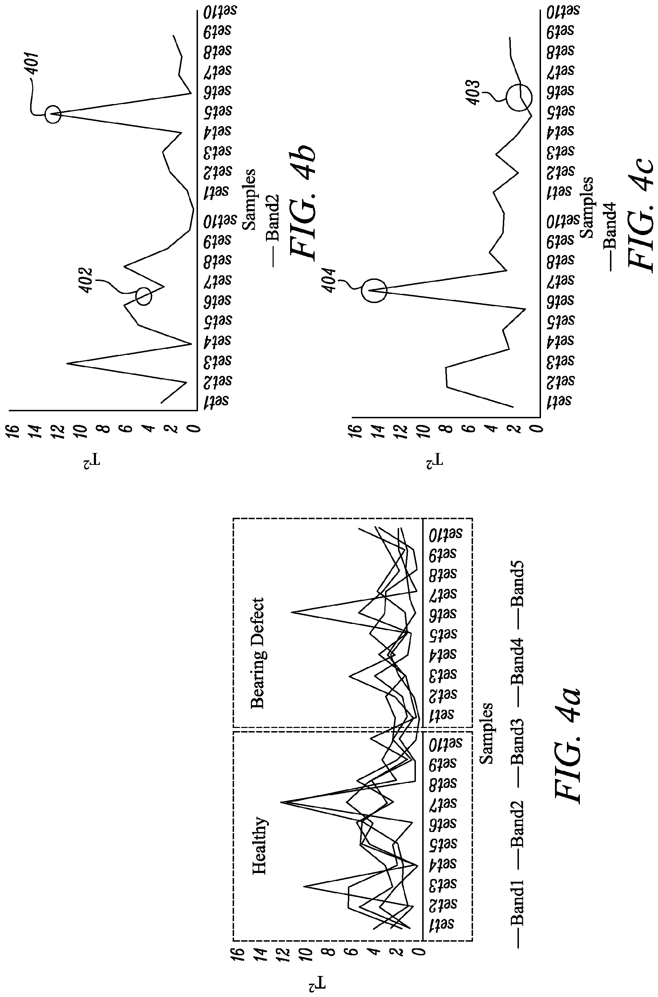

Figure 4a illustrates another example, in this case a comparison of T² measures between a healthy system and a system with a bearing defect, in this example with an inner race defect of the bearing. The T² measures change significantly for bands 2 and 4. In band 2, shown separately in Figure 4b, set 6 of the faulty system shows a T² measure 401 substantially higher than the T² measure 402 for the healthy system. In band 4, shown separately in Figure 4c, set 7 of the faulty system shows a T² measure 403 substantially lower than the T² measure 404 for the healthy system.

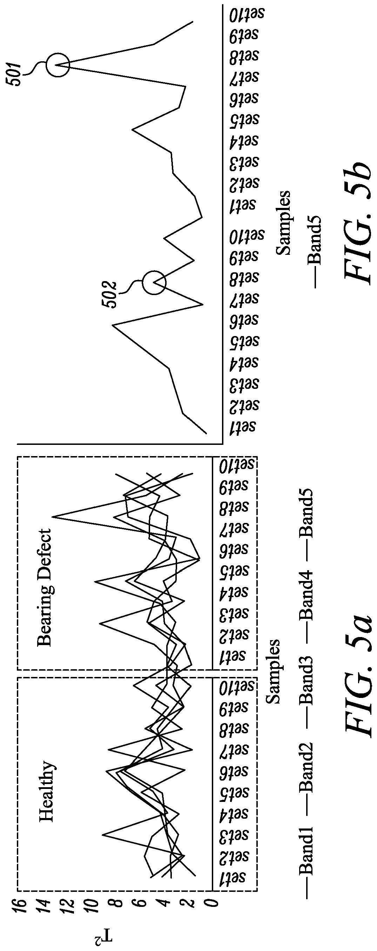

Figure 5a illustrates another example, in this case a comparison of T² measures between a healthy system and a system with a bearing defect, in this example with a ball defect in the bearing. The T² measure changes significantly for band 5, shown separately in Figure 5b, in which set 8 of the faulty system shows a T² measure 501 substantially higher than the T² measure 502 for the healthy system.

The above examples demonstrate that the method can be used to determine the presence, and type, of a bearing defect, for example determining a defect in an outer or inner race of the bearing or a fault in a ball of the bearing. The method can also be used for fault detection in varying operating conditions and can identify different mechanical faults, for example in a bearing or gearbox and to detect other faults such as eccentricity. In an implementation, a check for a fault can involve determining which band, i.e. which harmonic frequency band, contains a difference in the T² measure to determine the presence and type of fault.

This method provides a technique for incipient fault detection in electrical power systems using available current measurements. The proposed approach can be incorporated in an EHM unit to detect fault initiation online in real-time. Instead of using different algorithms to cater different faults in the electrical asset, the proposed method is a unified approach, which can be used to detect all the faults in an electrical power system. The current signals are processed in such a way that only the fault information is taken for further EHM processing, thereby reducing computational time and effort.

Thermal, mechanical and electrical stresses are main reasons for electromechanical failure in an electrical power system. Therefore, if failure modes are not detected at an early stage, this can lead to a severe failure in the power electronics converter, for example involving a capacitor or semiconductor switch failure, phase-to-phase or phase-to-ground failures in the electrical machine windings, or mechanical failures in a bearing or gearbox connected to the electrical machine. Hence, incipient fault detection assists in continuous monitoring and is able to detect maintenance requirements in advance.

Fault detection based on the method described herein can be applied to any type of electrical power system, including power converters, permanent magnet machines, induction machines, wound field synchronous machine, 6-phase or 12-phase machines designed for UAM (Urban Air Mobility) or CAP (Commuter Aircraft Programme) applications respectively.

## Claims

1. A fault detection method for an electrical power system (100) comprising a power electronics converter (102) connected to an electrical machine (101), the method comprising:
i) measuring an electric current (la, Ib) through a winding of the electrical machine (101) over a measurement time period to acquire a first set of time domain current data;
ii) transforming the first set of time domain current data to the frequency domain to provide a set of frequency domain current data;
iii) dividing the set of frequency domain current data into a plurality of frequency bands, each frequency band containing a harmonic frequency of operation of the electrical machine (101);
iv) transforming each of the plurality of frequency bands into the time domain to provide a second set of time domain current data for each frequency band;
v) calculating a plurality of statistical measures of each second set of time domain current data;
vi) applying principal components analysis to the plurality of statistical measures for each second set of time domain current data;
vii) calculating a Mahalanobis distance for each second set of time domain data; and
viii) determining a fault if any of the calculated Mahalanobis distances is anomalous compared to a baseline measure.

2. The method of claim 1, wherein the method is carried out over a plurality of measurement time periods to acquire a plurality of first sets of time domain current data.

3. The method of claim 2, wherein step viii) comprises determining a maximum difference between the calculated Mahalanobis distances and the baseline measure over the plurality of measurement time periods.

4. The method of any preceding claim, wherein step ii) comprises defining each frequency band by a central frequency, an upper bound frequency and a lower bound frequency, each central frequency corresponding to a fundamental frequency or harmonic frequency of operation of the electrical machine.

5. The method of any preceding claim, wherein step i) comprises acquiring the first set of time domain current data by sampling the current data at a sampling frequency over a predetermined number of samples.

6. The method of any preceding claim, wherein the plurality of frequency bands comprises a fundamental frequency band and first, second, third and fourth harmonic frequency bands.

7. The method of any preceding claim, wherein the plurality of statistical measures includes kurtosis, RMS, skewness and variance.

8. The method of any preceding claim, wherein the fault is in the electrical machine, or in a bearing (106) or a gearbox (107) coupled to the electrical machine (101).

9. An electrical power system (100) comprising:
a DC power source (103);
an electrical machine (101);
a power electronics converter (102) connected to convert a DC supply from the DC power source to an AC supply for driving the electrical machine (101);
a mechanical load (108) connected to the electrical machine (101); and
a condition monitoring unit (104) configured to:
i) measure an electric current (la, Ib) through a winding of the electrical machine (101) over a measurement time period to acquire a first set of time domain current data;
ii) transform the first set of time domain current data to the frequency domain to provide a set of frequency domain current data;
iii) divide the set of frequency domain current data into a plurality of frequency bands, each frequency band containing a harmonic frequency of operation of the electrical machine (101);
iv) transform each of the plurality of frequency bands into the time domain to provide a second set of time domain current data for each frequency band;
v) calculate a plurality of statistical measures of each second set of time domain current data;
vi) apply principal components analysis to the plurality of statistical measures for each second set of time domain current data;
vii) calculate a Mahalanobis distance for each second set of time domain data; and
viii) determine a fault if any of the calculated Mahalanobis distances is anomalous compared to a baseline measure.

10. The electrical power system (100) of claim 9, wherein the condition monitoring unit (104) is configured to measure the electric current over a plurality of measurement time periods to acquire a plurality of first sets of time domain current data.

11. The electrical power system (100) of claim 10, wherein in step viii) the condition monitoring unit (104) is configured to determine a fault based on a maximum difference between the calculated Mahalanobis distances and the baseline measure over the plurality of measurement time periods.

12. The electrical power system (100) of any one of claims 9 to 11, wherein each frequency band is defined by a central frequency, an upper bound frequency and a lower bound frequency, each central frequency corresponding to a fundamental frequency or harmonic frequency of operation of the electrical machine (101).

13. The electrical power system (100) of any one of claims 9 to 12, wherein the condition monitoring unit (104) is configured to acquire the first set of time domain current data by sampling the current data at a sampling frequency over a predetermined number of samples.

14. The electrical power system (100) of any one of claims 9 to 13, wherein the plurality of frequency bands comprises a fundamental frequency band and first, second, third and fourth harmonic frequency bands.

15. The electrical power system (100) of any one of claims 9 to 14, wherein the plurality of statistical measures includes kurtosis, RMS, skewness and variance.
